# EUROPEAN PATENT APPLICATION

(11) **EP 3 082 330 A1**
(43) Date of publication of application: **19.10.2016**
(21) Application number: 14880363.8
(22) Date of filing: 26.01.2014
(51) Int. Cl.: H04N 5/225, H04M 1/02, H01R 12/50

(54) **MAINBOARD STRUCTURE AND TERMINAL**

(71) Applicant: Huawei Device Co., Ltd., Shenzhen, Guangdong 518129 (CN)
(72) Inventor: LIANG, Huanbing, Shenzhen, Guangdong 518129 (CN); LI, Quanli, Shenzhen, Guangdong 518129 (CN); LI, Chao, Shenzhen, Guangdong 518129 (CN); ZHU, Guangyao, Shenzhen, Guangdong 518129 (CN)
(74) Representative: Körber, Martin Hans
(86) International application number: PCT/CN2014/071518
(87) International publication number: WO 2015/109584

(57) **Abstract**

Embodiments of the present invention relate to the field of communications, and disclose a mainboard structure and a terminal, in which an overall thickness of the terminal is reduced. A specific solution is as follows: A mainboard structure includes a printed circuit board PCB mainboard, where at least one hollow zone is arranged on the PCB mainboard; and the mainboard structure further includes: a land grid array LGA module one-to-one corresponding to the hollow zone, where an area of a first surface of the LGA module is greater than an area of the hollow zone corresponding to the LGA module; the first surface of the LGA module includes a first region and a second region, where the first region corresponds to the hollow zone, and is used for arranging a key-height component thereon; and the second region is electrically connected to a first surface of the PCB mainboard.

## Description

### TECHNICAL FIELD

The present invention relates to the communications field, and in particular, to a mainboard structure and a terminal.

### BACKGROUND

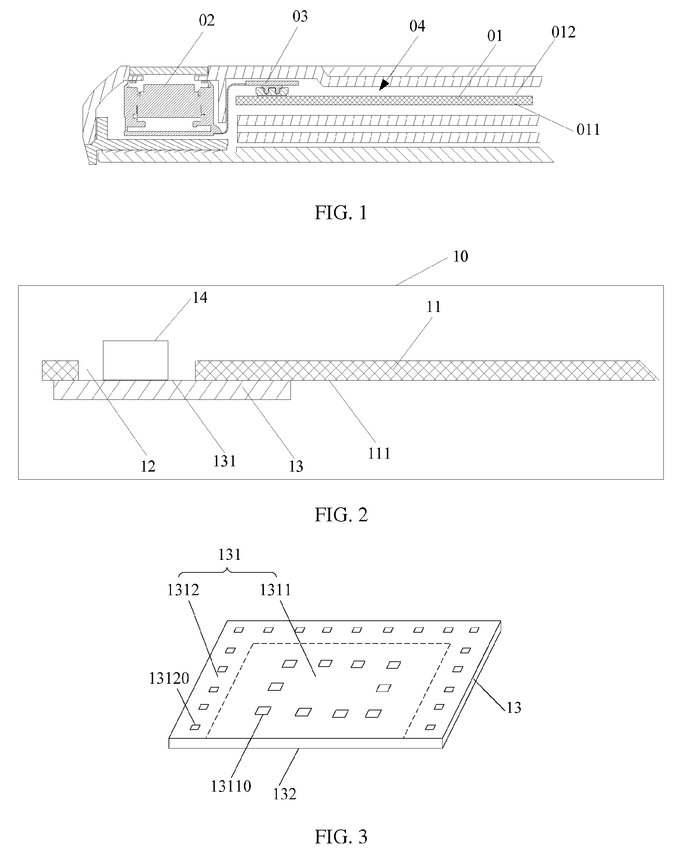

With continuous development of society, a lighter and thinner industrial design has become a general trend for terminal screen products. As is known to all, an early-stage stacking design of terminal screen products involves arrangement of some key-height components (for example, a connector of a camera, and an earphone) that affect a thickness of a product, and many companies perform normalization processing on these key-height components to reduce costs. The normalization processing on the key-height components causes an increase in an overall thickness of the product in some scenarios, and affects user experience. For example, a camera is customized according to a stacking design manner of a mobile phone in an early stage, where the stacking design of the mobile phone allows components to be arranged on both sides of a printed circuit board (Printed circuit board, PCB) mainboard, and a connector of the camera should be arranged on a rear side of the PCB mainboard. However, in a sectional view of a terminal shown in FIG. 1, during stacking design of the terminal, to reduce an overall thickness, components are allowed to be arranged only on a first surface 011 of the PCB mainboard 01. However, because normalized processing has been performed on a connector 03 of a camera 02, if the connector 03 of the camera 02 is arranged on the first surface 011, an end, provided with a connection cable, of the connector 03 is located on a side that is away from the camera 02, and in this case, the connector 03 cannot be connected to the camera 02 because the connection cable for the camera 02 is excessively short. Therefore, the connector 03 of the camera 02 has to be arranged on a second surface 012 on which components cannot be arranged. This wastes space 04 shown in FIG. 1 and causes a failure in reducing the thickness of the terminal; consequently, the overall thickness of the terminal cannot meet a desired requirement, an overall design effect of the product is affected, and user experience is degraded.

### SUMMARY

Embodiments of the present invention provide a mainboard structure and a terminal, in which an overall thickness of the terminal is reduced.

To achieve the foregoing objective, the following technical solutions are used in the embodiments of the present invention:

According to a first aspect of the present invention, a mainboard structure is provided, including a printed circuit board PCB mainboard, where at least one hollow zone is arranged on the PCB mainboard; and the mainboard structure further includes: a land grid array LGA module one-to-one corresponding to the hollow zone, where
a first surface of the LGA module includes a first region and a second region; the first region corresponds to the hollow zone, and is used for arranging a key-height component thereon; and the second region is electrically connected to a first surface of the PCB mainboard.

With reference to the first aspect, in one possible implementation manner,
a solder pad is arranged in the first region, and the first region is welded with the at least one key-height component by using the solder pad arranged in the first region.

With reference to the first aspect and the foregoing possible implementation manner, in another possible implementation manner,
a solder pad is arranged in the second region, and the second region is welded with the first surface of the PCB mainboard by using the solder pad arranged in the second region.

With reference to the first aspect and the foregoing possible implementation manners, in another possible implementation manner,
the first surface of the PCB mainboard is used for arranging at least one component thereon.

With reference to the first aspect and the foregoing possible implementation manners, in another possible implementation manner,
the first surface of the PCB mainboard is used for arranging at least one component thereon, a second surface of the PCB mainboard is used for arranging at least one component thereon, and the second surface of the PCB mainboard is opposite to the first surface of the PCB mainboard.

With reference to the first aspect and the foregoing possible implementation manners, in another possible implementation manner,
a second surface of the LGA module is used for arranging at least one component thereon, and the second surface of the LGA module is opposite to the first surface of the LGA module.

With reference to the first aspect and the foregoing possible implementation manners, in another possible implementation manner,
a thickness of the LGA module is less than a height of a highest component in the at least one component arranged on the first surface of the PCB mainboard.

According to a second aspect of the present invention, a terminal is provided, including a mainboard structure, where
the mainboard structure includes a printed circuit board PCB mainboard, where at least one hollow zone is arranged on the PCB mainboard; and the mainboard structure further includes: a land grid array LGA module one-to-one corresponding to the hollow zone, where
a first surface of the LGA module includes a first region and a second region; the first region corresponds to the hollow zone, and is used for arranging a key-height component thereon; and the second region is electrically connected to a first surface of the PCB mainboard.

With reference to the second aspect, in one possible implementation manner, the terminal further includes: a key-height component, where
the key-height component is a component whose height is greater than a preset threshold.

With reference to the second aspect and the foregoing possible implementation manner, in another possible implementation manner,
the key-height component is a connector of a camera, or an earphone.

The embodiments of the present invention provide a mainboard structure and a terminal. The mainboard structure includes a PCB mainboard, where at least one hollow zone is arranged on the PCB mainboard; and the mainboard structure further includes a land grid array (Land Grid Array, LGA) module one-to-one corresponding to the hollow zone, where the LGA module is electrically connected to a first surface of the PCB mainboard by using a second region included in a first surface of the LGA module, and a key-height component is connected on a first region included in the first surface of the LGA module that corresponds to the hollow zone, so that the key-height component is located in the hollow zone of the PCB mainboard, thereby reducing an overall thickness of the terminal.

### BRIEF DESCRIPTION OF DRAWINGS

To describe the technical solutions in the embodiments of the present invention or in the prior art more clearly, the following briefly describes the accompanying drawings required for describing the embodiments or the prior art. Apparently, the accompanying drawings in the following description show merely some embodiments of the present invention, and a person of ordinary skill in the art may still derive other drawings from these accompanying drawings without creative efforts.
FIG. 1 is a sectional view of a terminal according to the prior art;
FIG. 2 is a sectional view of a mainboard structure according to Embodiment 1 of the present invention;
FIG. 3 is a schematic structural diagram of an LGA module according to Embodiment 1 of the present invention;
FIG. 4 is a side view of a mainboard structure according to Embodiment 1 of the present invention;
FIG. 5 is a side view of another mainboard structure according to Embodiment 1 of the present invention;
FIG. 6 is a side view of still another mainboard structure according to Embodiment 1 of the present invention;
FIG. 7 is a side view of yet another mainboard structure according to Embodiment 1 of the present invention; and
FIG. 8 is a sectional view of a terminal according to Embodiment 2 of the present invention.

### DESCRIPTION OF EMBODIMENTS

The following clearly and completely describes the technical solutions in the embodiments of the present invention with reference to the accompanying drawings in the embodiments of the present invention. Apparently, the described embodiments are merely some but not all of the embodiments of the present invention. All other embodiments obtained by a person of ordinary skill in the art based on the embodiments of the present invention without creative efforts shall fall within the protection scope of the present invention.

### Embodiment 1

Embodiment 1 of the present invention provides a mainboard structure 10 shown in FIG. 2, and the mainboard structure 10 may include: a PCB mainboard 11, where at least one hollow zone 12 is arranged on the PCB mainboard 11; and the mainboard structure 10 may further include an LGA module 13 one-to-one corresponding to the hollow zone 12.

FIG. 3 is a schematic structural diagram of an LGA module 13 according to an embodiment of the present invention. As shown in FIG. 2 and FIG. 3, an area of a first surface 131 of the LGA module 13 is greater than an area of the hollow zone 12 corresponding to the LGA module 13; the first surface 131 of the LGA module 13 includes a first region 1311 and a second region 1312; the first region 1311 corresponds to the hollow zone 12, and is used for arranging a key-height component 14 thereon; and the second region 1312 is electrically connected to a first surface 111 of the PCB mainboard 11.

In the schematic structural diagram of the LGA module 13 shown in FIG. 3, shapes of the first region 1311 and the second region 1312 may be determined according to a shape of the hollow zone 12 arranged on the PCB mainboard 11. This embodiment of the present invention merely provides an example for description herein, but does not limit the shapes of the first region 1311 and the second region 1312.

It should be noted that the key-height component 14 described in this embodiment of the present invention is a component whose height is greater than a preset threshold (where the preset threshold may be determined according to a requirement of an actual application scenario), for example, a connector of a camera, or an earphone, and examples are not listed one by one herein in this embodiment of the present invention.

It should be noted that, in a schematic diagram, shown in FIG. 2, of the mainboard structure 10 provided in this embodiment of the present invention, a position and a size of the hollow zone 12 arranged on the PCB mainboard 11 are merely a schematic diagram provided to facilitate comprehension by a person skilled in the art, the position and the size of the hollow zone 12 arranged on the PCB mainboard 11 included in the mainboard structure 10 may be set according to a requirement of an actual application scenario, and herein, this embodiment of the present invention does not specifically limit the position and the size of the hollow zone 12 arranged on the PCB mainboard included in the mainboard structure 10. In addition, in the mainboard structure 10 provided by this embodiment of the present invention, a quantity of hollow zones 12 arranged on the PCB mainboard 11 may be set according to a requirement of an actual application scenario, and herein, this embodiment of the present invention does not specifically limit the quantity of hollow zones 12 arranged on the PCB mainboard 11 included in the mainboard structure 10 either.

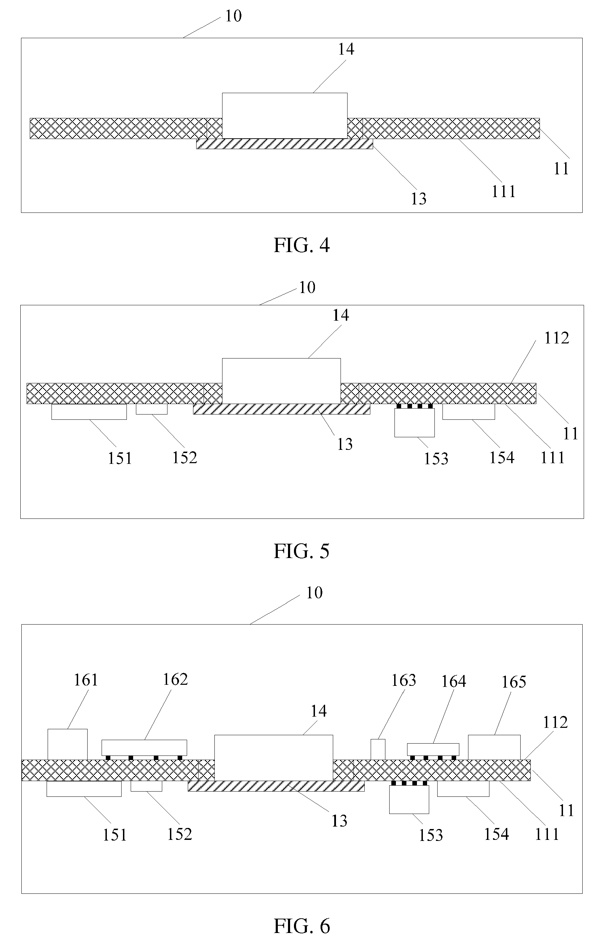

In this embodiment of the present invention, further optionally, a solder pad 13110 is arranged in the first region 1311 included in the first surface 131 of the LGA module 13 shown in FIG. 3. FIG. 4 is a side view of a mainboard structure 10 according to an embodiment of the present invention. As shown in FIG. 2 to FIG. 4, the first region 1311 is welded with at least one key-height component 14 by using the solder pad 13110 arranged in the first region 1311, so that the key-height component 14 is located in the hollow zone 12 corresponding to the LGA module 13.

The LGA module 13 described in this embodiment of the present invention may be electrically connected to the first surface 111 of the PCB mainboard 11 by using the second region 1312 included in the first surface 131, and the key-height component 14 is welded with the first region 1311 included in the first surface 131 of the LGA module 13; in this way, data acquired by the key-height component 14 is transmitted to the solder pad 13120 arranged in the second region 1312 through the solder pad 13110 arranged in the first region 1311, and then is transmitted to the PCB mainboard 11, so that a central processing unit processes the data acquired by the key-height component 14.

In this embodiment of the present invention, the key-height component 14 is welded on the first region 1311 of the LGA module 13, so that the key-height component 14 is located in the hollow zone 12 that is arranged on the PCB mainboard 11 and that corresponds to the LGA module 13, thereby reducing a thickness of a product. For example, a thickness of the PCB mainboard 11 is H, a height of the key-height component 14 is h, and a height of a highest component in the at least one component arranged on the first surface 111 of the PCB mainboard 11 is A (where in order to reduce the thickness of the product, components are allowed to be arranged on only the first surface 111 of the PCB mainboard 11, and in one possible implementation manner, the thickness of the LGA module 13 is less than the height of the highest component in the at least one component arranged on the first surface 111 of the PCB mainboard 11). In this case, if the key-height component 14 is directly welded on a second surface 112 of the PCB mainboard 11 according to the arrangement manner of the prior art shown in FIG. 1, the thickness of the product is a sum of the thickness of the PCB mainboard 11, the height of the key-height component 14, and the height of the highest component in the at least one component arranged on the first surface 111 of the PCB maim board 11, that is, H+h+A. If the key-height component 14 is welded on the first surface 131 of the LGA module 13 according to an arrangement manner, shown in FIG. 2, provided by this embodiment of the present invention, the thickness of the product is a sum of the height of the key-height component 14 and the height of the highest component in the at least one component arranged on the first surface 111 of the PCB mainboard 11, that is, h+A. In other words, by means of the arrangement manner of this embodiment of the present invention, the thickness of the product is reduced by H, that is, the thickness of the PCB mainboard 11, and in this way, an objective of reducing the overall thickness of the terminal is achieved.

In this embodiment of the present invention, further optionally, a solder pad 13120 is arranged in the second region 1312 included in the first surface 131 of the LGA module 13 shown in FIG. 3. As shown in FIG. 2 to FIG. 4, the second region 1312 is welded with the first surface 111 of the PCB mainboard 11 by using the solder pad 13120 arranged in the second region 1312.

In this embodiment of the present invention, further optionally, in one possible implementation manner of this embodiment of the present invention, referring to FIG. 5, which is a side view of a mainboard structure 10 according to an embodiment of the present invention, in the side view of the mainboard structure 10 shown in FIG. 5, the first surface 111 of the PCB mainboard 11 is used for arranging at least one component thereon. For example, in the side view of the mainboard structure 10 shown in FIG. 5, a component 151, a component 152, a component 153, and a component 154 are arranged on the first surface 111 of the PCB mainboard 11.

In this embodiment of the present invention, the first surface 111 of the PCB mainboard 11 may be a component arrangement surface, and in some products, in order to reduce a thickness of a final product, components are allowed to be arranged on only one side of the PCB mainboard 11; in other words, on the second surface 112, opposite to the first surface 111 of the PCB mainboard 11, of the PCB mainboard 11, no component is allowed to be arranged. In addition, the mainboard structure 10 provided by the present invention achieves a best product thickness reducing effect in an application scenario in which components are allowed to be arranged on only one side of the PCB mainboard 11.

In this embodiment of the present invention, further optionally, in one possible implementation manner of this embodiment of the present invention, referring to FIG. 6, which is a side view of a mainboard structure 10 according to an embodiment of the present invention, in the side view of the mainboard structure 10 shown in FIG. 6, the first surface 111 of the PCB mainboard 11 is used for arranging at least one component thereon. For example, in the side view of the mainboard structure 10 shown in FIG. 6, a component 151, a component 152, a component 153, and a component 154 are arranged on the first surface 111 of the PCB mainboard 11. In addition, the second surface 112 of the PCB mainboard 11 is also used for arranging at least one component thereon, and the second surface 112 of the PCB mainboard 11 is opposite to the first surface 111 of the PCB mainboard 11. For example, in the side view of the mainboard structure 10 shown in FIG. 6, a component 161, a component 162, a component 163, a component 164, and a component 165 are arranged on the second surface 112 of the PCB mainboard 11.

In this embodiment of the present invention, when components are allowed to be arranged on the first surface 111 and the second surface 112 of the PCB mainboard 11, and a height of a highest component in the at least one component arranged on the second surface 112 is less than the height of the key-height component 14, the mainboard structure 10 provided by this embodiment of the present invention can still reduce the overall thickness of the product. For example, the height of the PCB mainboard 11 is H, the height of the key-height component 14 is h, the height of the highest component in the at least one component arranged on the first surface 111 of the PCB mainboard 11 is A, and the height of the highest component in the at least one component arranged on the second surface 112 of the PCB mainboard 11 is B (where in one possible implementation manner, the thickness of the LGA module 13 is less than the height of the highest component in the at least one component arranged on the first surface 111 of the PCB mainboard 11); in this scenario, when the height of the key-height component 14 is greater than a sum of the height of the highest component in the at least one component arranged on the second surface 112 and the thickness of the PCB mainboard 11, the overall thickness of the product is reduced by the thickness H of the PCB mainboard 11; when the height of the key-height component 14 is less than a sum of the height of the highest component in the at least one component arranged on the second surface 112 and the thickness of the PCB mainboard 11, the overall thickness of the product is reduced by the height of the key-height component 14 minus the height of the highest component in the at least one component arranged on the second surface 112 of the PCB mainboard 11, that is, h-B.

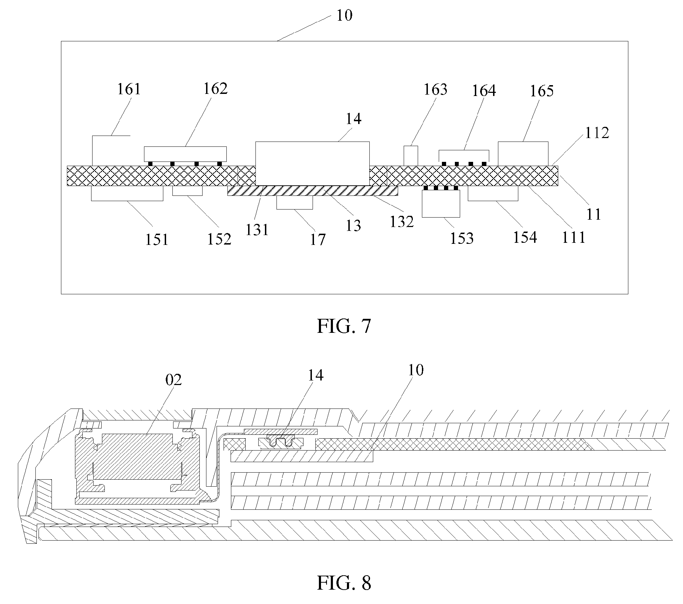

In this embodiment of the present invention, further optionally, referring to FIG. 7, which is a side view of a mainboard structure 10 according to an embodiment of the present invention, a second surface 132 of the LGA module 13 may also be used for arranging at least one component 17 thereon, and the second surface 132 of the LGA module 13 is opposite to the first surface 131 of the LGA module 13.

In this embodiment of the present invention, further optionally, to reduce the thickness of the mainboard structure 10 as much as possible, the thickness of the LGA module 13 is less than the height of the highest component in the at least one component arranged on the first surface 111 of the PCB mainboard 11.

It should be noted that the mainboard structure 10 provided by this embodiment of the present invention may be applied to terminal screen products, and is also applicable to products whose design is increasingly miniaturized, such as a mobile phone, a fixed station, and a router, which is not specifically limited by this embodiment of the present invention herein.

A mainboard structure provided by this embodiment of the present invention includes a PCB mainboard, where at least one hollow zone is arranged on the PCB mainboard; and the mainboard structure further includes an LGA module one-to-one corresponding to the hollow zone, where the LGA module is electrically connected to a first surface of the PCB mainboard by using a second region included in a first surface of the LGA module, and a key-height component is connected on a first region included in the first surface of the LGA module that corresponds to the hollow zone, so that the key-height component is located in the hollow zone of the PCB mainboard, thereby reducing an overall thickness of a terminal.

### Embodiment 2

Embodiment 2 of the present invention provides a terminal, and as shown in FIG. 8, the terminal includes the mainboard structure 10 shown in FIG. 2.

The mainboard structure 10 includes a PCB mainboard, where at least one hollow zone is arranged on the PCB mainboard; and the mainboard structure 10 further includes: a land grid array LGA module one-to-one corresponding to the hollow zone.

A first surface of the LGA module includes a first region and a second region; the first region corresponds to the hollow zone, and is used for arranging a key-height component 14 thereon; and the second region is electrically connected to a first surface of the PCB mainboard.

In this embodiment of the present invention, further optionally, the terminal may further include: the key-height component 14. The key-height component 14 is a component whose height is greater than a preset threshold.

In this embodiment of the present invention, further optionally, the key-height component 14 is a connector of a camera, or an earphone.

For example, in the terminal shown in FIG. 8, the key-height component 14 is a connector of a camera 02 (where in the terminal shown in FIG. 8, a board to board (Board to Board, BTB) connector is used as an example of the key-height component 14). According to the sectional views of the terminal shown in FIG. 1 and FIG. 8, it can be clearly seen that, after the mainboard structure 10 provided by this embodiment of the present invention is used, space 04 shown in FIG. 1 is saved, an objective of reducing an overall thickness of the terminal is achieved, and user experience is improved.

The terminal provided by this embodiment of the present invention includes a mainboard structure, where the mainboard structure includes a PCB mainboard, and at least one hollow zone is arranged on the mainboard structure; and the mainboard structure further includes an LGA module one-to-one corresponding to the hollow zone, where the LGA module is electrically connected to a first surface of the PCB mainboard by using a second region included in a first surface of the LGA module, and a key-height component is connected on a first region included in the first surface of the LGA module that corresponds to the hollow zone, so that the key-height component is located in the hollow zone of the PCB mainboard, thereby reducing an overall thickness of the terminal.

In the several embodiments provided by the present application, it should be understood that the disclosed apparatus and method may be implemented in other manners. For example, the described apparatus embodiment is merely exemplary. For example, the module or unit division is merely logical function division and may be other division in actual implementation. For example, a plurality of units or components may be combined or integrated into another apparatus, or some features may be ignored or not performed. In addition, the displayed or discussed mutual couplings or direct couplings or communication connections may be implemented through some interfaces. The indirect couplings or communication connections between the apparatuses or units may be implemented in electronic, mechanical, or other forms.

The units described as separate parts may or may not be physically separate, and parts displayed as units may be one or more physical units, may be located in one place, or may be distributed on different places. Some or all of the units may be selected according to actual needs to achieve the objectives of the solutions of the embodiments.

The foregoing descriptions are merely specific implementation manners of the present invention, but are not intended to limit the protection scope of the present invention. Any variation or replacement readily figured out by a person skilled in the art within the technical scope disclosed in the present invention shall fall within the protection scope of the present invention. Therefore, the protection scope of the present invention shall be subject to the protection scope of the claims.

## Claims

1. A mainboard structure, comprising a printed circuit board, PCB, mainboard, wherein at least one hollow zone is arranged on the PCB mainboard; and the mainboard structure further comprises:
a land grid array, LGA, module one-to-one corresponding to the hollow zone, wherein
a first surface of the LGA module comprises a first region and a second region; the first region corresponds to the hollow zone, and is used for arranging a key-height component thereon; and the second region is electrically connected to a first surface of the PCB mainboard.

2. The mainboard structure according to claim 1, wherein
a solder pad is arranged in the first region, and the first region is welded with the at least one key-height component by using the solder pad arranged in the first region.

3. The mainboard structure according to claim 1 or 2, wherein
a solder pad is arranged in the second region, and the second region is welded with the first surface of the PCB mainboard by using the solder pad arranged in the second region.

4. The mainboard structure according to any one of claims 1 to 3, wherein
the first surface of the PCB mainboard is used for arranging at least one component thereon.

5. The mainboard structure according to any one of claims 1 to 3, wherein
the first surface of the PCB mainboard is used for arranging at least one component thereon, a second surface of the PCB mainboard is used for arranging at least one component thereon, and the second surface of the PCB mainboard is opposite to the first surface of the PCB mainboard.

6. The mainboard structure according to any one of claims 1 to 5, wherein
a second surface of the LGA module is used for arranging at least one component thereon, and the second surface of the LGA module is opposite to the first surface of the LGA module.

7. The mainboard structure according to any one of claims 1 to 6, wherein
a thickness of the LGA module is less than a height of a highest component in the at least one component arranged on the first surface of the PCB mainboard.

8. A terminal, comprising the mainboard structure according to any one of claims 1 to 7.

9. The terminal according to claim 8, wherein the terminal further comprises: a key-height component, wherein
the key-height component is a component whose height is greater than a preset threshold.

10. The terminal according to claim 9, wherein
the key-height component is a connector of a camera, or an earphone.
